# FASCICULE DE BREVET EUROPEEN

(11) **EP 4 312 128 B1**
(45) Date de publication et mention de la délivrance du brevet: **01.07.2026**
(21) Numéro de dépôt: 23185414.2
(22) Date de dépôt: 13.07.2023
(51) Int. Cl.: G06F 12/02, G11C 16/10, G11C 16/34, G11C 16/08, G11C 16/22

(54) **PROCEDE DE GESTION D'UNE MEMOIRE D'UN ELEMENT SECURISE**
VERFAHREN ZUR VERWALTUNG EINES SPEICHERS EINES SICHEREN ELEMENTS
METHOD FOR MANAGING A MEMORY OF A SECURE ELEMENT

(30) Priorité: 28.07.2022 FR 2207787
(43) Date de publication de la demande: 31.01.2024
(73) Titulaire: IDEMIA France, 92400 Courbevoie (FR)
(72) Inventeur: COURQUIN, Yannick, 92400 Courbevoie (FR)
(74) Mandataire: Idemia

(56) Documents cités:
- EP-A2- 1 182 669
- WO-A1-2009/100149
- FR-A1- 2 977 047
- US-A1- 2004 057 316
- US-A1- 2007 294 490
- US-A1- 2009 172 340
- US-A1- 2011 271 046
- US-A1- 2013 024 609
- US-A1- 2021 019 050

## Description

**La présente** invention concerne le domaine de la gestion d'une mémoire, notamment la gestion de la mémoire non volatile d'un élément sécurisé.

Les éléments sécurisés traditionnellement utilisés pour s'authentifier sur les réseaux de téléphonie mobile incluent les cartes de circuit intégré universelles UICC (pour « Universal Integrated Circuit Card »), notamment les cartes SIM (pour « Subscriber Identity Module » - ou module d'identité d'abonné). Chaque carte comprend, outre un système d'exploitation (ou OS pour « Operating System » en terminologie anglaise), des données, ici des données de souscription, par exemple un identifiant IMSI (pour « International Mobile Subscriber Identity »), des clés cryptographiques et des algorithmes (ou applications, programmes ou logiciels), spécifiques à un abonnement fourni par un opérateur de téléphonie mobile.

Le système d'exploitation a vocation à piloter l'utilisation des ressources matérielles de la carte par les applications installées.

Des cartes eUICC (pour « embedded UICC » - ou UICC embarquée) ont également vu le jour, telles que définies par le groupe GSMA (pour « Global System for Mobile Communications Association »), notamment dans le standard GSMA SGP.02 v3.2 intitulé « Remote Provisioning Architecture for Embedded UICC - Technical Specification - Version 4.0 » en date du 25 février 2019.

Les cartes eUICC sont reprogrammables et permettent de charger plusieurs profils d'abonné (ou profils de communication) au sein de la même carte eUICC, ainsi que de mettre à jour et/ou supprimer un ou plusieurs de ces profils d'abonné. Ces profils d'abonné peuvent comprendre des applications et des données personnalisées. Ils sont typiquement stockés dans une mémoire non volatile réinscriptible de la carte. Dans la suite du texte, le terme « stocké » est à comprendre au sens « mémorisé ». Pour ajouter un nouveau profil d'abonné, modifier un profil d'abonné existant, ou lancer une application à partir d'un profil d'abonné existant, il est nécessaire d'effacer et/ou d'écrire des données dans la mémoire non volatile réinscriptible de l'élément sécurisé (eUICC ou autre).

Si les systèmes d'exploitation ont traditionnellement été stockés en mémoire morte, type ROM (Read-Only Memory), en raison de la nature immuable de l'OS, ils sont désormais stockés en mémoire non volatile réinscriptible des éléments sécurisés. Cela permet à la **fois certaines** mises à jour de l'OS, mais également d'incorporer un seul type de mémoire non volatile dans ces éléments sécurisés.

Aussi, d'une façon générale, la mémoire non volatile réinscriptible d'un élément sécurisé est généralement composée d'une pluralité de blocs mémoire, chaque bloc mémoire comprenant un ensemble de pages mémoire qui peuvent être effacées et/ou (ré)écrites.

Une zone de la mémoire non volatile réinscriptible, dite zone OS, est formée de l'ensemble des pages mémoire stockant le système d'exploitation. Le reste de la mémoire est généralement une zone Données, formée de l'ensemble des pages mémoire pour le stockage des données (donc hors système d'exploitation).

Dans ce qui suit, une « page mémoire » correspond à l'unité minimale de la mémoire pour l'effacement de données (c'est-à-dire qu'un effacement de données ne peut avoir lieu que pour une ou plusieurs pages complète(s), et non sur une partie de page seulement). L'écriture (ou « programmation ») peut quant à elle être effectuée sur seulement une partie de page. Il est noté que le vocabulaire employé pour désigner ces éléments peut varier d'un type de mémoire à l'autre ou selon le fabricant de la carte mémoire. Par exemple, le terme « secteur » est parfois utilisé pour désigner l'unité minimale de la mémoire pour l'effacement de données. La personne du métier n'aura bien entendu aucune difficulté à appliquer les enseignements suivants à des éléments sécurisés fournis par des fabricants utilisant une autre terminologie que celle employée ici.

Toute page d'une mémoire non volatile réinscriptible a une certaine capacité d'endurance (ou simplement « endurance »), qui correspond au nombre maximal de fois que l'on peut effacer et (ré)écrire la page mémoire. Une fois que ce nombre maximal est atteint, la page mémoire est « usée » et peut ne plus être apte à restituer, en lecture, les données qui y ont été préalablement écrites et/ou à permettre une (ré)écriture de données et/ou à permettre un (ré)effacement de données. La capacité d'endurance peut varier d'une page à l'autre. Lorsque toutes les pages mémoire sont usées, le fonctionnement correct de la mémoire n'est plus assuré. La capacité d'endurance « globale » (i.e. en tenant compte de l'ensemble des pages mémoire) est très variable selon le type de mémoire non volatile réinscriptible (flash, EEPROM - de l'anglais « Electrically Erasable Programmable Read Only Memory », etc.). Elle peut aller de quelques milliers de cycles d'écritures et d'effacements pour certaines mémoires non volatiles réinscriptibles à plusieurs centaines de milliers de cycles pour d'autres.

Certaines opérations nécessitent plus d'effacements et d'écritures que d'autres, et « usent » davantage la mémoire. Par exemple, le téléchargement d'un nouveau profil d'abonné requiert généralement plus d'effacements et d'écritures que l'utilisation ou la mise à jour d'une application déjà installée sur un profil d'abonné existant. Si de telles opérations sont effectuées alors que la mémoire a atteint un état d'usure trop avancé, il est possible que tout ou partie des effacements / écritures ne puissent être effectués sur la mémoire. Cela peut engendrer des défaillances au niveau de l'utilisation de l'élément sécurisé, voire une interruption totale du fonctionnement de celui-ci. Le document WO2009/100149 A1 divulgue une mémoire flash segmentée en plusieurs régions, dont une zone OS et une zone de données applicatives. Le document US2011/271046 A1 divulgue une gestion d'usure de mémoire non volatile réinscriptible.basée sur des compteurs d'usure.

La brevet FR 2 977 047 B1 propose un procédé pour gérer de manière efficace l'écriture et l'effacement de données dans une mémoire non volatile, en fonction de son état d'usure. Il permet notamment de substituer un secteur mémoire de travail usé par un secteur mémoire de remplacement, disponible dans une réserve de secteurs mémoire. Cela permet a priori d'épuiser au maximum l'ensemble de la zone mémoire dédiée au stockage des données. Néanmoins, ces solutions ne sont pas optimales lorsque l'on souhaite étendre au maximum la durée de vie de la mémoire d'un élément sécurisé. La présente invention vient améliorer la situation.

### Exposé de l'invention

L'inventeur a en effet constaté que les techniques connues faisaient fi de la zone mémoire dédiée à l'OS, laquelle, en raison de la nature peu, voire, non évolutive du système d'exploitation se trouvait très peu usée à la fin de vie de l'élément sécurisé. Aussi, l'invention propose d'exploiter cette réserve indirecte de pages mémoire saines, comme nouvelles pages mémoire de stockage de données précédemment stockées sur une page mémoire usée, par exemple par une simple interversion des contenus des pages mémoire.

L'OS se retrouve alors transféré, en tout ou partie, sur des pages mémoire usées, ce qui ne lui est pas préjudiciable, en raison de la nature peu évolutive, voire non évolutive, du système d'exploitation (donc peu de nouveaux cycles d'écriture auront lieu). En revanche, les données déplacées peuvent à nouveau être l'objet de nombreux cycles de réécritures.

A cet effet, l'invention propose un procédé de gestion d'une mémoire non volatile réinscriptible dans un élément sécurisé, la mémoire comportant une première zone formée de pages mémoire, dites pages mémoire OS, stockant un système d'exploitation, OS, et une seconde zone formée de pages mémoire, dites pages mémoire de données, pour stocker des données, le procédé comprenant les étapes suivantes :
- déterminer si au moins une première page mémoire de données est usée, et
- dans l'affirmative, déplacer le contenu de la première page mémoire de données usée vers une page mémoire OS tout en déplaçant le contenu de cette page mémoire OS vers une page mémoire de données usée.

Par « pages mémoire OS », il est entendu l'ensemble des pages ou secteurs de la mémoire qui stockent initialement le code compilé de l'OS. Par « pages mémoire de données », il est entendu l'ensemble des pages ou secteurs de la mémoire qui sont destinés au stockage des données autres que le code compilé de l'OS, qu'elles comportent ou non du contenu (c'est-à-dire des données). **Il** peut s'agir d'applications ou logiciels exécutés dans l'environnement de l'OS (par exemple du code compilé relatif aux applications ou logiciels), mais également des données (profils, données de programmes, données d'applications, fichiers, etc.) générées ou obtenues lors de l'utilisation de l'élément sécurisé.

Les pages mémoire OS et pages mémoire de données peuvent initialement former deux partitions dissociées au sein de la mémoire physique.

Par « page mémoire usée », il est entendu une page mémoire ayant déjà subi un nombre important de cycles d'effacement/écriture s'approchant d'un état d'usure trop avancé où de nouveaux cycles sont susceptibles d'être mal effectués.

Selon l'invention, il est donc possible de procéder à nouveau à des cycles d'écritures pour les données déplacées, désormais stockées dans les pages mémoire initialement OS qui ont statistiquement un état moins usé. De la sorte, la durée de vie de l'élément sécurisé est prolongée, réduisant son impact environnemental et contribuant par conséquent au développement durable et à la préservation des ressources.

Des caractéristiques facultatives des modes de réalisation de l'invention sont définies dans les revendications annexées. Certaines de ces caractéristiques sont expliquées ci-dessous en référence à un procédé, tandis qu'elles peuvent être transposées en caractéristiques de dispositif.

Dans un mode de réalisation, l'étape de déplacement comporte l'interversion (i.e. la permutation ou l'échange) du contenu stocké sur la première page mémoire de données usée avec le contenu stocké sur la page mémoire OS. L'interversion permet de simplifier la gestion des pages mémoire.

En variante, le contenu stocké sur la page mémoire OS est déplacé vers une page mémoire de données usée différente de la première page mémoire usée. Cette configuration est possible lorsqu'il existe des pages mémoire usées disponibles qui ne stockent pas de données utiles. C'est par exemple le cas lorsque l'invention est mise en œuvre après épuisement des pages saines (i.e. non usées) de la seconde zone (stockant les données) par des mécanismes de remplacement de pages tels que ceux du brevet FR 2 977 047 B1 suscité (les secteurs de travail usés sont alors disponibles).

Cette configuration de l'invention présente l'avantage de ne pas nécessiter de mémoire de sauvegarde (ou « backup » en terminologie anglaise) pour réaliser le déplacement du contenu des pages mémoire manipulées. En effet, le contenu (portion d'OS) de la page mémoire OS peut être directement déplacé dans la page mémoire usée disponible, laissant la page mémoire OS disponible à son tour pour recevoir le contenu de la première page mémoire détectée comme usée.

Dans un mode de réalisation, l'étape de détermination est en réponse à une étape d'écriture d'une donnée sur la première page mémoire de données. Les opérations selon l'invention sont ainsi déclenchées après l'exécution d'une instruction d'écriture. Cela réduit les risques d'erreur d'écriture.

Dans un mode de réalisation, chaque page mémoire de données déterminée comme usée est marquée comme telle, et le déplacement comprend les étapes suivantes :
déterminer un taux d'usure globale d'un bloc de pages mémoire de données, et
si le taux d'usure globale atteint un seuil d'usure globale, déplacer le contenu des pages mémoire de données du bloc vers la première zone, tout en déplaçant le contenu de l'ensemble des pages mémoire OS contenant l'ensemble du système d'exploitation vers des pages mémoire de données.

Dans cette réalisation, l'OS est déplacé d'un seul bloc pour libérer de la place mémoire « saine », lorsque la zone de données est trop endommagée. Ainsi, les opérations risquées de déplacement de contenu sont limitées dans le temps.

Le taux d'usure globale est fonction du marquage des pages mémoire de données de l'ensemble du bloc. Aussi, dans un mode de réalisation spécifique, le taux d'usure globale est représentatif d'un nombre de pages mémoire de données usées ou d'une proportion de pages mémoire de données usées dans le bloc. Le seuil d'usure globale est donc une valeur correspondante en nombre de pages ou en proportion.

Dans un mode de réalisation spécifique, le bloc de pages mémoire de données est de taille équivalente (e.g. la même) à celle de la première zone (donc du bloc formé par les pages mémoire OS stockant le système d'exploitation).

Dans une alternative au déplacement global du système d'exploitation, l'OS stocké est un OS compilé, composé d'une pluralité de sections pouvant être stockées de façon indépendante, chacune étant stockée sur un bloc respectif de pages mémoire OS, et le déplacement comprend les étapes suivantes :
sélectionner une ou plusieurs des sections de l'OS,
déplacer le contenu de la première page mémoire de données usée vers une page mémoire OS stockant la ou les sections sélectionnées, tout en déplaçant le contenu du ou des blocs de pages mémoire OS stockant la ou les sections de l'OS sélectionnées vers un bloc de page mémoire de données.

Un déplacement progressif est ainsi réalisé. Il permet avantageusement de traiter spécifiquement des petites zones de données fortement utilisées et donc usées plus rapidement que le reste de la mémoire de données.

Dans un mode de réalisation spécifique, le déplacement comprend les étapes suivantes :
sélectionner un bloc de pages mémoire de données, incluant la première page mémoire de données usée, de taille équivalente au bloc ou blocs de pages mémoire OS stockant la ou les sections de l'OS sélectionnées, et
intervertir le contenu du bloc sélectionné de pages mémoire de données avec celui du bloc ou des blocs de pages mémoire OS stockant la ou les sections de l'OS sélectionnées. On évite ainsi une inutilisation de certaines pages mémoire OS « saines ». De préférence les blocs sont construits de tailles équivalentes ou égales.

Dans un mode de réalisation spécifique, le bloc sélectionné de pages mémoire de données est formé d'une pluralité de pages mémoire contigües. Cela permet un déplacement de contenu plus aisé.

Dans un autre mode de réalisation spécifique, sélectionner le bloc de pages mémoire de données comprend les étapes suivantes :
obtenir un ensemble de pages mémoire de données contigües, incluant la première page mémoire de données usée, en fonction d'un critère d'usure globale desdites pages mémoire de l'ensemble. Un tel ensemble va donc préférentiellement englober (de façon optimisée) un nombre élevé de pages usées. Le taux d'usure globale peut être fixé comme décrit ci-dessus (en fonction par exemple d'un marquage des pages successivement identifiées comme usées), et
mettre à jour l'ensemble de pages mémoire de données (par exemple par extension aux pages voisines) en fonction de la ou les sections de l'OS sélectionnées, pour obtenir ledit bloc de pages mémoire de données. Cela permet de faire correspondre en taille l'ensemble de pages mémoire de données avec la taille du bloc ou des blocs stockant lesdites sections.

Selon une caractéristique particulière, sélectionner une ou plusieurs des sections de l'OS comprend sélectionner le plus petit ensemble d'une ou plusieurs sections contiguës de l'OS ayant une taille supérieure à l'ensemble obtenu de pages mémoire de données.

Ces dispositions permettent d'optimiser le dimensionnement des blocs à intervertir, afin de minimiser le nombre de pages mémoire OS non utilisées après déplacement du contenu.

Selon une autre caractéristique particulière, le déplacement est déclenché par l'identification d'un ensemble de pages mémoire de données contigües, incluant la première page mémoire de données usée, présentant un taux d'usure globale supérieur à un seuil d'usure globale. En variante, l'atteinte d'un taux d'usure particulier de la première page mémoire de données usée au-delà d'un seuil critique (une page mémoire peut être considérée comme usée à partir d'un seuil d'usure plus faible que le seuil critique) peut déclencher la procédure de déplacement (obtention d'un bloc de pages incluant notamment cette page mémoire à l'usure critique).

Cela rend plus efficace le déplacement du contenu de pages mémoire par bloc.

Dans un mode de réalisation, le procédé comprend en outre une étape consistant à déterminer si le contenu de la première page mémoire de données usée doit être déplacé. Des critères déjà évoqués ci-dessus incluent notamment la détection d'un taux d'usure globale (de la zone 1 ou d'un ensemble de pages). En évitant le systématisme d'un déplacement, la gestion de la mémoire est allégée.

Dans un mode de réalisation particulier, la détermination de si le contenu de la première page mémoire de données usée doit être déplacé est basée sur un type de page mémoire de données associé à la première page mémoire de données usée. Cela permet par exemple de définir un premier type de page indéplaçable, par exemple en raison de la nature des données qu'elles comportent (clés cryptographiques, zone système, adresses mémoire de base, etc.) et un deuxième type de page dont le contenu peut être déplacé.

Dans un mode de réalisation particulier, dans l'affirmative d'une détermination que le contenu de la première page mémoire de données usée doit être déplacé, la première page mémoire de données usée est marquée comme étant à déplacer (par exemple via un drapeau), et
le procédé comprend en outre, lors d'un redémarrage de l'élément sécurisé, une étape de vérification de si une page mémoire de données usée est marquée comme étant à déplacer, et dans l'affirmative une étape de déclenchement du déplacement du contenu de ladite page mémoire de données marquée comme étant à déplacer, vers la page mémoire OS.

Ainsi le déplacement de contenu selon l'invention est réalisé hors utilisation de l'élément sécurisé, réduisant les risques de corruption des données (déplacées ou manipulées lors d'une opération de l'élément sécurisé) ou de dysfonctionnement de l'OS compte tenu des déplacements réalisés.

Cette configuration est utile lorsque l'OS n'est pas entièrement chargé en mémoire RAM lors de l'utilisation de l'élément sécurisé, afin d'éviter un dysfonctionnement de l'OS lors du déplacement des parties non en RAM si elles doivent être appelées au même moment.

Selon une caractéristique particulière, le procédé comprend, en outre, le déclenchement d'un redémarrage de l'élément sécurisé en réponse au marquage de la première page mémoire de données usée comme étant à déplacer. Cela garantit la prise en compte de déplacement le plus tôt possible, dès lors que le déplacement requiert un redémarrage.

En variante, le déplacement est réalisé immédiatement à la détermination de l'état usé de la page mémoire. Cette variante s'apparente à un déplacement à la volée des contenus.

Dans un mode de réalisation, le procédé comprend, en outre, une mise à jour d'un registre d'indirection pour stocker une information représentative d'une nouvelle adresse mémoire des contenus déplacés (donc portion d'OS déplacée et données déplacées). Ce registre peut être une table de translation d'adresses, entre les adresses initiales et les nouvelles adresses mémoire. Selon les réalisations, l'information peut être une valeur relative (par exemple le déplacement ou offset d'adresse mémoire) ou une valeur absolue d'adresse mémoire.

Dans un mode de réalisation, le déplacement est conditionné au fait que la deuxième zone ne comporte plus de page mémoire de données non usée qui soit libre. Des mécanismes classiques prolongeant la vie de cette zone mémoire « données » peuvent ainsi être mis en œuvre de façon préalable à l'invention. Dans ce sens, des déplacements de données sont d'abord effectués à l'intérieur de la zone mémoire « données » lorsqu'une page est usée, et ce n'est qu'après épuisement de toutes les pages « saines » que les pages mémoire OS sont utilisées pour prolonger encore plus la durée de vie de la mémoire.

Dans un mode de réalisation, la page mémoire OS vers laquelle est déplacé le contenu de la première page mémoire de données usée est distincte d'une page mémoire usée dans laquelle le contenu d'une page mémoire OS a déjà été déplacé. Cela évite notamment de déplacer une seconde fois une portion d'OS déjà déplacée (initialement vers une page mémoire déjà usée). Cette disposition contribue à l'efficacité du mécanisme selon l'invention en évitant de replacer des données sur une page mémoire de données déjà usée.

Dans un mode de réalisation, le procédé comporte en outre, lorsque la page mémoire OS vers laquelle a été déplacé le contenu de la première page mémoire de données usée est déterminée comme étant usée, le déplacement dudit contenu de cette page mémoire OS usée vers une seconde page mémoire OS. Cette disposition permet de prolonger la durée de vie de la mémoire lorsque certaines données sont réécrites de façon intensive. Elle s'applique par exemple dans le cas d'un OS morcelé en sections, où lesdites données déplacées le sont d'un premier bloc de pages mémoire OS vers un second bloc de pages mémoire OS, lorsque le premier bloc s'avère être usé (par exemple selon un critère évoqué ci-dessus).

Un autre aspect de l'invention concerne un élément sécurisé comprenant un processeur et une mémoire non-volatile réinscriptible, la mémoire non-volatile réinscriptible comportant une première zone formée de pages mémoire, dites pages mémoire OS, stockant un système d'exploitation, OS, et une seconde zone formée de pages mémoire, dites pages mémoire de données, pour stocker des données, l'élément sécurisé étant configuré pour :
- déterminer si au moins une première page mémoire de données est usée, et
- dans l'affirmative, déplacer le contenu de la première page mémoire de données usée vers une page mémoire OS tout en déplaçant le contenu de cette page mémoire OS vers une page mémoire de données usée.

Par exemple, la mémoire peut être une mémoire non volatile par exemple réinscriptible de type FLASH.

Un autre aspect de l'invention concerne un terminal hôte comprenant un élément sécurisé tel que défini précédemment.

La présente invention vise également un programme informatique comportant des instructions pour la mise en œuvre du procédé ci-dessus, lorsque ce programme est exécuté par un processeur.

Ce programme peut utiliser n'importe quel langage de programmation (par exemple, un langage objet ou autre), et être sous la forme d'un code source interprétable, d'un code partiellement compilé ou d'un code totalement compilé.

L'invention vise également un support d'enregistrement non transitoire lisible par un ordinateur sur lequel est enregistré un programme pour la mise en œuvre du procédé ci-dessus, lorsque ce programme est exécuté par un processeur.

Au moins une partie des procédés selon l'invention peut être mise en œuvre par ordinateur. En conséquence, la présente invention peut prendre la forme d'un mode de réalisation entièrement matériel, d'un mode de réalisation entièrement logiciel (comportant les microprogrammes, les logiciels résidents, les microcodes, etc.) ou d'un mode de réalisation combinant des aspects logiciels et matériels qui peuvent tous être globalement appelés ici "circuit", "module" ou "système". De plus, la présente invention peut prendre la forme d'un produit de programme informatique incorporé dans tout support d'expression tangible disposant d'un code de programme utilisable par ordinateur incorporé dans le support.

Étant donné que la présente invention peut être mise en œuvre dans un logiciel, la présente invention peut être incorporée sous forme de code lisible par ordinateur pour être fournie à un appareil programmable sur tout support adapté. Un support tangible ou non transitoire peut comprendre un support de stockage tel qu'un lecteur de disque dur, un dispositif de bande magnétique ou un dispositif de mémoire à semi-conducteurs et analogues. Un support transitoire peut comporter un signal tel qu'un signal électrique, un signal électronique, un signal optique, un signal acoustique, un signal magnétique ou un signal électromagnétique, par exemple un signal hyperfréquence ou RF (radiofréquence).

### Brève description des dessins

**D'autres** caractéristiques, détails et avantages de l'invention apparaîtront à la lecture de la description détaillée ci-après. Celle-ci est purement illustrative et doit être lue en regard des dessins annexés, sur lesquels :
La figure 1 représente schématiquement un dispositif hôte comprenant un élément sécurisé embarqué selon un mode de réalisation de l'invention ;
Les figures 2a, 2b, 2c représentent, à titre illustratif, différentes organisations d'une mémoire non volatile réinscriptible d'un élément sécurisé auxquelles peuvent être appliqués un ou plusieurs modes de réalisation de l'invention ;
La figure 3 illustre, à l'aide d'un ordinogramme, des étapes d'un procédé de gestion d'une mémoire non volatile réinscriptible NVM2 selon un ou plusieurs modes de réalisation avec déplacement global du système d'exploitation ; et
La figure 4 illustre, à l'aide d'un ordinogramme, des étapes d'un procédé de gestion d'une mémoire non volatile réinscriptible selon un ou plusieurs modes de réalisation avec déplacement progressif (ou morcelé ou parcellaire) du système d'exploitation.

### Description détaillée

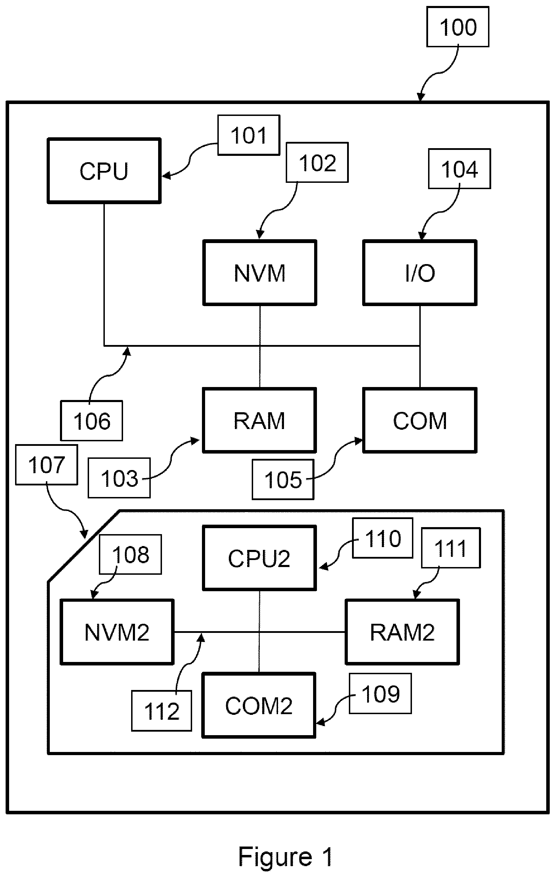

La Figure 1 représente schématiquement un dispositif hôte 100 comprenant un élément sécurisé 107 selon un ou plusieurs modes de réalisation de l'invention.

Le dispositif hôte 100 peut être par exemple un terminal mobile, un téléphone portable, une tablette numérique ou tout type d'équipement électronique. L'élément sécurisé 107 est incorporé dans le dispositif hôte 100.

Le dispositif hôte 100 peut comprendre un bus de communication 106 auquel peuvent être reliées :
- une unité de traitement 101, nommée sur la figure CPU (pour « Central Processing Unit ») et pouvant comporter un ou plusieurs processeurs ;
- une ou plusieurs mémoires non volatiles (ou « NVM » pour Non-Volatile Memory) 102, par exemple non réinscriptible telle une ROM (pour « Read Only Memory ») et/ou réinscriptible telle une EEPROM (pour « Electrically Erasable Read Only Memory ») ou une mémoire Flash ;
- une mémoire vive 103 ou RAM (pour « Random Access Memory ») ;
- une interface 104 d'entrée/sortie, nommée sur la figure I/O (pour « Input/Output »), par exemple un écran, un clavier, une souris ou un autre dispositif de pointage tel qu'un écran tactile ou une télécommande permettant à un utilisateur d'interagir avec le système via une interface graphique ; et
- une interface de communication 105, nommée COM sur la figure, adaptée à échanger des données par exemple avec un serveur SM-SR (pour « subscription manager-security routing » en anglais) via un réseau, ou une interface de lecture/écriture.

L'élément sécurisé 107 peut être par exemple une carte à circuit intégré universelle et embarquée (eUICC). Il peut comprendre un bus de communication 112 auquel peuvent être reliées :
- une unité de traitement 110 ou microprocesseur, nommée sur la figure CPU2 ;
- une ou plusieurs mémoires non volatiles 108 notées NVM2, de type réinscriptibles, par exemple une EEPROM ou mémoire Flash. NVM2 stocke typiquement un système d'exploitation de carte, noté OS, des applications ou logiciels s'exécutant dans l'OS et des données utilisées ou générées lors de l'utilisation de l'élément sécurisé. Un contrôleur de mémoire assure les fonctions classiques de gestion de la mémoire NVM2 (écriture, lecture, effacement, code correcteur d'erreur, etc.) ;
- une mémoire vive 111 notée RAM2 ; et
- une interface de communication 109, nommée COM2 sur la figure, adaptée à échanger des données avec le processeur 101 du dispositif hôte 100.

La mémoire vive 111 de l'élément sécurisé 107 peut comprendre des registres adaptés à l'enregistrement des variables et paramètres créés et modifiés au cours de l'utilisation de l'élément sécurisé 107, typiquement au cours de l'exécution du système d'exploitation, des applications qu'il héberge mais également d'un programme informatique comprenant des instructions pour la mise en œuvre d'un procédé selon l'invention. Typiquement, les codes d'instructions du programme stocké en mémoire non-volatile 108 sont chargés en mémoire RAM2 111 en vue d'être exécutés par l'unité de traitement CPU2 110.

La mémoire non-volatile 108 de l'élément sécurisé 107 est typiquement une mémoire réinscriptible de type EEPROM ou une mémoire Flash pouvant constituer un support au sens de l'invention, c'est-à-dire pouvant comprendre un programme informatique comprenant des instructions pour la mise en œuvre des procédés selon l'invention.

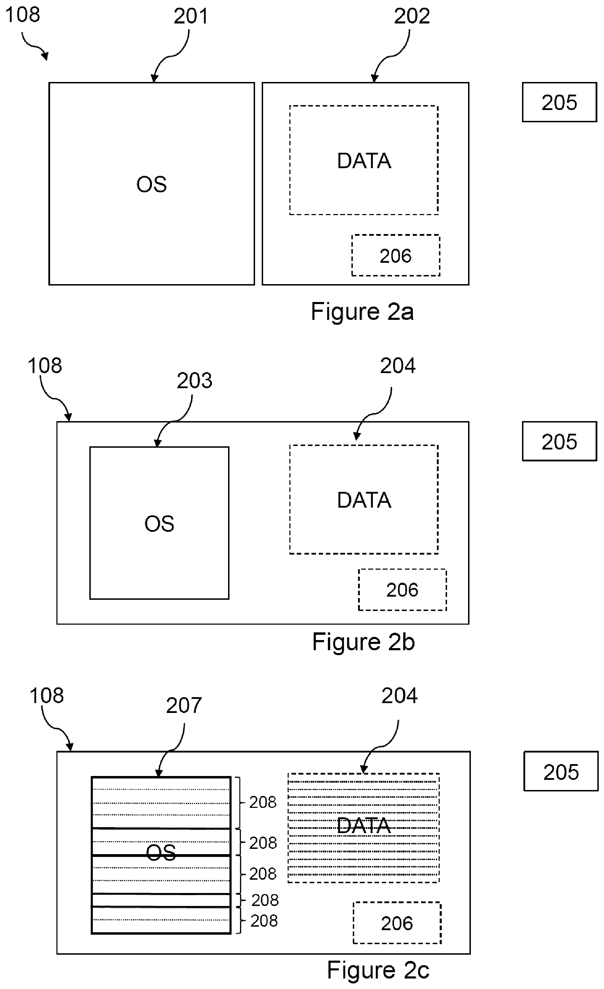

Les Figures 2a à 2c représentent différentes organisations d'une mémoire non volatile réinscriptible d'un élément sécurisé auxquelles peuvent être appliqués un ou plusieurs modes de réalisation de l'invention.

Comme mentionné ci-avant, une mémoire, par exemple la mémoire non volatile réinscriptible NVM2 108 de l'élément sécurisé 107, comprend une pluralité de blocs mémoire, dans lequel chaque bloc mémoire comprend un ensemble de pages mémoire sur lesquelles des données peuvent être écrites et/ou effacées. Il est rappelé que, dans ce qui suit, le terme « page mémoire » est utilisé pour désigner l'unité minimale pour effacer des données de la mémoire. L'écriture (on parle aussi de « programmation ») peut quant à elle être effectuée sur seulement une partie de page.

Classiquement, chaque fabricant de carte mémoire fournit une valeur appelée endurance native, qui correspond à la capacité d'endurance minimale assurée pour toutes les pages mémoire de la carte. Par exemple, une endurance native de 10 000 cycles indique que chaque page mémoire peut supporter au moins 10 000 cycles d'écritures et d'effacements. Certaines pages mémoire peuvent supporter des capacités d'endurance bien supérieures à cette endurance native (ici, 10 000 cycles), et il existe une grande variabilité dans les valeurs individuelles des capacités d'endurance des différentes pages mémoire.

Selon un ou plusieurs modes de réalisation de la présente invention, la mémoire non volatile réinscriptible NVM2 108 de l'élément sécurisé 107 est organisée comme représenté sur la Figure 2a. Sur la Figure 2a, la mémoire non volatile réinscriptible 108 (par exemple, une mémoire de type Flash) comprend deux partitions logiques définissant deux zones de mémoire distinctes : une première partition logique 201, dite zone mémoire OS, nommée OS sur la figure, dédiée au stockage du système d'exploitation de l'élément sécurisé et une deuxième partition logique 202, dite zone mémoire de données, nommée DATA sur la figure, dédiée au stockage des autres données, typiquement des applications, des données de profils et de personnalisation, des données générées par les applications, etc.

Dans une variante de réalisation illustrée sur la Figure 2b, la mémoire non volatile réinscriptible NVM2 108 de l'élément sécurisé 107 comprend une unique partition logique dans laquelle sont stockés le système d'exploitation de l'élément sécurisé et les autres données (applications, profils, etc.). Une première zone 203, dite zone mémoire OS, nommée OS sur la figure, stocke le système d'exploitation de l'élément sécurisé alors qu'une deuxième zone 204, dite zone mémoire de données, nommée DATA sur la figure, stocke les autres données et comporte des sous-zones disponibles pour le stockage de données additionnelles. La zone mémoire de données peut être le complément de la zone mémoire OS dans la mémoire NVM2.

**Chaque zone** comprend une pluralité de pages mémoire (non représentées sur les Figures 2a-2b). A titre illustratif, une page mémoire est constitué de N octets contigus (N est typiquement une puissance de 2, par exemple 256, 512, 1024), les pages mémoire étant contigües au sein de la mémoire NVM2.

A titre illustratif toujours, la mémoire NVM2 d'un élément sécurisé 107 peut présenter une capacité de 512 kilo-octets (ko) ou 1024 ko. La taille de l'OS est par exemple de 200 à 300 ko. En fonctionnement classique, la taille des autres données stockées dans l'élément sécurisé est d'environ 100 à 200 ko. Néanmoins, cela peut fortement fluctuer selon les usages de l'élément sécurisé.

Il existe, dans l'état de la technique, des procédés de gestion de l'endurance de la mémoire au niveau de la zone mémoire de données 202 ou 204, qui permettent d'améliorer l'endurance globale d'une mémoire et d'exploiter avantageusement la variabilité des capacités d'endurance des différentes pages mémoire. Par exemple, dans le brevet FR 2 977 047 B1, la zone mémoire de données 202 ou 204 est avantageusement partitionnée en deux sous-zones logiques de pages mémoire : une zone de travail et une zone de remplacement (appelée aussi « réservoir d'endurance », ou « réservoir de remplacement » correspondant aux pages mémoire de données non encore utilisées). La zone de travail comprend une ensemble de pages mémoire appelées « pages de travail » ou « pages principales ». Lorsqu'une page de travail est identifiée comme « usée », son contenu est redirigé vers une autre page soit principale (s'il y en a une de disponible) soit de remplacement. Par exemple, lorsque de nouvelles données doivent être écrites dans une page de travail mais que celle-ci est usée, son contenu est copié vers une autre page et les nouvelles données y sont écrites. Dans un ou plusieurs modes de réalisation, la redirection du contenu de la page de travail vers une autre page est effectuée à l'aide d'un pointeur comprenant l'adresse de la nouvelle page. En outre, lorsqu'une telle nouvelle page est usée à son tour, son contenu est redirigé vers encore une autre page (principale ou de remplacement) non usée.

Par « page usée », il est entendu une page mémoire ayant atteint sa capacité d'endurance et sur laquelle il n'est plus possible d'effacer et/ou d'écrire des données de façon correcte. Il est noté qu'une page mémoire est « utilisée » (i.e. la page a déjà fait l'objet d'au moins une écriture ou effacement) avant d'être « usée » (i.e. le nombre d'écritures / effacements maximal est atteint pour la page). Un procédé pour déterminer qu'une page mémoire est usée ou non est détaillé dans le brevet FR 2 977 047 B1 et rappelé par la suite.

Au fur et à mesure que des données sont écrites sur des pages mémoire de la zone mémoire de données 202 ou 204, celles-ci s'usent, jusqu'à atteindre éventuellement leurs capacités d'endurance. Lorsqu'une page mémoire, par exemple une page de travail, est nouvellement déterminée comme étant usée, le contenu de cette page est copié sur une autre page disponible de la zone mémoire de données 202 ou 204, typiquement un autre page « vierge » (i.e. qui n'a jamais encore été utilisée, c'est-à-dire dans laquelle aucune donnée n'a encore été écrite/copiée) disponible en mémoire jusqu'à épuisement des pages mémoire de données. Lorsqu'il ne reste plus de page mémoire de données disponible pour recevoir le contenu d'une page mémoire déterminée comme étant usée, la mémoire non-volatile NVM2 n'est plus fiable. L'élément sécurisé 107 est alors considéré en fin de vie.

Afin de prolonger la vie de l'élément sécurisé 107 et ainsi réduire l'impact environnemental de celui-ci, il est proposé d'utiliser les pages mémoire OS de la zone mémoire OS 201, 203 comme pages de substitution pour les pages mémoire de données usées.

Traditionnellement, le système d'exploitation de carte n'est pas ou très peu évolutif dans le temps. Il est par conséquent classique de ne pas manipuler la zone mémoire OS 201, 203 durant la vie de l'élément sécurisé 107, à l'exception des lectures pour chargement de l'OS en mémoire vive RAM2. La réutilisation des pages mémoire OS comme stock de pages mémoire « saines » pour suppléer n'est donc pas intuitive.

Néanmoins, comme ces pages mémoire OS sont susceptibles de rester « saines » compte tenu de l'absence ou du faible nombre de cycles d'effacement/d'écriture comparativement à une page mémoire usée, leur réutilisation comme pages de substitution pour les pages mémoire de données usées présente indéniablement des avantages pour prolonger la durée de vie de la mémoire NVM2.

Aussi, l'invention prévoit-elle de déterminer si au moins une première page mémoire de données est usée, et dans l'affirmative, de déplacer le contenu de la première page mémoire de données usée vers une page mémoire OS tout en déplaçant le contenu de cette page mémoire OS vers une page mémoire de données usée.

Pour déterminer si une page mémoire est usée ou non, il est possible d'utiliser le procédé décrit dans le brevet FR 2 977 047 B1, qui repose sur l'évaluation de la qualité d'effacement ou de programmation d'une page mémoire. Cette qualité d'effacement est mesurée en comparant les tensions de seuil des transistors correspondant aux cellules mémoires d'une page mémoire donnée à un ou plusieurs seuils prédéfinis. Une telle détermination est connue et n'est donc pas détaillée davantage.

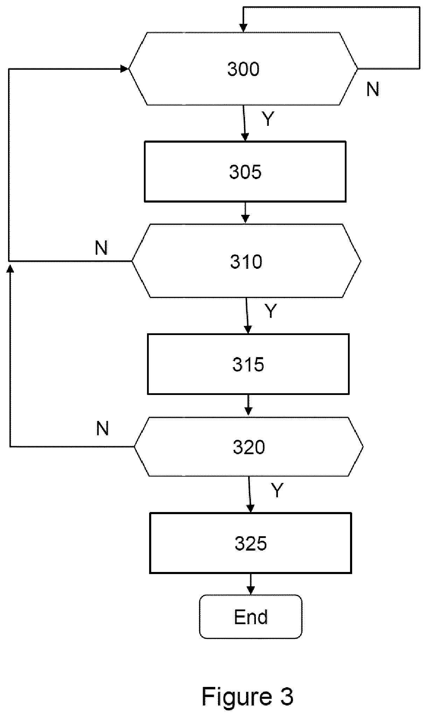

Comme détaillé en référence à la Figure 3, l'invention propose, dans un ou plusieurs modes de réalisation, de déplacer, d'un coup, le contenu des pages mémoire de données d'un bloc vers la première zone mémoire OS 201, 203, tout en déplaçant le contenu de l'ensemble des pages mémoire OS contenant l'ensemble du système d'exploitation vers des pages mémoire de données de la zone mémoire de données 202 ou 204.

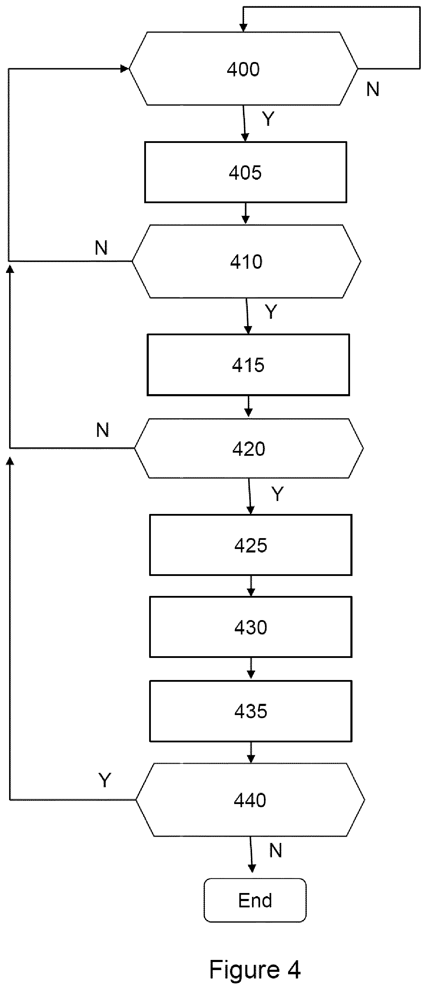

Ces modes de réalisation font donc référence à un déplacement global du système d'exploitation pour récupérer, d'un coup, l'ensemble des pages mémoire OS formant le zone mémoire OS 201, 203. Ces modes de réalisation s'opposent à ceux relatifs à un déplacement parcellaire ou morcelé du système d'exploitation, comme décrit ci-dessous en référence à la Figure 4.

Le système d'exploitation peut avoir été compilé sous forme de code « délocalisable » ou « relocalisable » (« relocatable code ») afin de faciliter son déplacement à l'intérieur de la mémoire non-volatile réinscriptible NVM2. Un code est dit « délocalisable » ou « relocalisable » lorsqu'il peut être chargé n'importe où dans la mémoire en raison d'une indépendance de celui-ci à sa position au sein de la mémoire. C'est le cas notamment lors de l'usage d'adresses relatives.

Un code « délocalisable » ou « relocalisable » permet notamment de décomposer le code en sections « indépendantes » qui peuvent être chargées n'importe où dans la mémoire, et donc être déplacées, indépendamment les unes des autres. Néanmoins, tout code faisant référence à une autre section peut être corrigé à l'aide d'une table de relocalisation (mémorisant le décalage) ; ainsi les sections peuvent être liées ensembles.

La Figure 3 illustre, à l'aide d'un ordinogramme, des étapes d'un procédé de gestion d'une mémoire non volatile réinscriptible NVM2 selon un ou plusieurs modes de réalisation avec déplacement global du système d'exploitation.

Une telle gestion de la mémoire peut être mise en œuvre après épuisement des pages mémoire de données comme évoqué par exemple ci-dessus. Dans ce cas-là, le déplacement du contenu d'une page mémoire de données usée vers la zone mémoire OS 201, 203 est conditionné au fait que la zone mémoire de données 202, 204 ne comporte plus de page mémoire de données non usée ou « saine » qui soit libre.

A l'étape 300, l'élément sécurisé est en attente d'une instruction d'écriture dans la zone mémoire de données 202, 204. On entend par « instruction d'écriture » toute instruction visant à modifier une donnée stockée dans un page mémoire de données, incluant par conséquent également une instruction d'effacement. Aussi, lorsqu'une telle instruction est reçue (branche « O » de l'étape 300), elle est exécutée à l'étape 305, conduisant à l'écriture sur une ou plusieurs pages mémoire de données, selon la taille des données à écrire ou à effacer. Si l'instruction reçue n'est pas une instruction d'écriture (branche « N » de l'étape 300), alors le procédé reboucle sur lui-même à l'étape 300 en attente d'une nouvelle instruction d'écriture.

Avec ces étapes 300 et 305, la suite du procédé conduisant au déplacement de contenus de pages mémoire usées est conditionnée ou « en réponse » à une étape d'écriture d'une donnée sur une page mémoire de données. D'autres conditions pourraient néanmoins être utilisées

A l'étape 310, un niveau d'usure de chacune des pages « écrites » est déterminé. Le procédé décrit dans le brevet FR 2 977 047 B1 peut être utilisé à cette fin.

Une page mémoire « écrite » peut s'avérer être usée (branche « O » de l'étape 310) auquel cas elle est marquée comme telle à l'étape 315. Aussi, au fur et à mesure des différentes écritures en mémoire NVM2, chaque page mémoire de données « écrite » qui est déterminée comme usée est marquée comme telle.

Le niveau d'usure déterminé est par exemple considéré comme « usé » s'il dépasse une valeur seuil d'usure préfixée THR1. Dans l'exemple des mécanismes du brevet FR 2 977 047 B1, si la qualité d'effacement mesurée en comparant les tensions de seuil est inférieure à un seuil d'usure, alors la page mémoire est considérée comme usée.

Le marquage peut consister en l'activation d'un drapeau « usée » associé à la page mémoire considérée. Par exemple, une table de drapeaux « usée » pour l'ensemble des pages mémoire de données peut être stockée dans un registre 205 (illustré en Figures 2a, 2b et 2c), pouvant éventuellement faire partie de la mémoire NVM2. En variante à l'usage d'un drapeau par page mémoire, un identifiant de la page mémoire (par exemple son adresse) peut être mémorisé dans le registre. Préférablement, au fur et à mesure que des plages contigües de pages mémoire usées se forment, des plages d'identifiants (en stockant l'identifiant de page de début et l'identifiant de page de fin) peuvent être stockées afin de réduire le nombre de registres utilisés.

Si aucune page mémoire n'est identifiée comme nouvellement usée (branche « N » de l'étape 310), alors le procédé repart à l'étape 300 en attente d'une nouvelle instruction d'écriture.

Une fois toutes les pages mémoire « écrites » traitées (celles de l'étape 305) et lorsqu'au moins une nouvelle page est marquée comme étant usée (donc suite à l'étape 315), l'élément sécurisé détermine à l'étape 320 un taux d'usure globale d'un bloc de pages mémoire de données de la zone mémoire de données 202, 204, qui inclut la ou les pages nouvellement marquées comme étant usées.

Il est question ici de déterminer si un bloc de la zone mémoire de données 202, 204 se retrouve être trop dégradé, justifiant un déplacement de son contenu vers la zone mémoire OS 201, 203.

Préférentiellement, le bloc de pages mémoire de données considéré ici est de taille équivalente (e.g. la même taille) à celle de la zone mémoire OS 201, 203. Cela vise à effectuer, le cas échéant, une substitution de contenus sans laisser des pages mémoire inutilisées.

Dans un mode de réalisation, la zone mémoire de données 202, 204 peut être découpée en N blocs disjoints de pages mémoire contigües, chaque bloc faisant la taille de la zone mémoire OS 201, 203 à l'exception éventuelle du dernier bloc. Dans ce cas, l'étape 320 s'intéresse au bloc incluant la ou les pages mémoire « écrites » nouvellement marquées comme étant usées.

Dans un autre mode de réalisation, la zone mémoire de données 202, 204 peut être découpée en M sous-blocs disjoints d'une ou plusieurs pages mémoire contigües et de même taille (à l'exception éventuelle du dernier bloc), cette taille étant par exemple un sous-multiple de celle de la zone mémoire OS 201, 203. Un sous-bloc comprend donc un ensemble d'une ou plusieurs pages mémoire contiguës. Dans ce cas, le bloc à considérer est formé de plusieurs sous-blocs disjoints consécutifs. Le bloc est donc formé de plusieurs pages mémoire. L'étape 320 peut alors s'intéresser à tous les blocs, chacun formé de plusieurs sous-blocs disjoints consécutifs, qui incluent la ou les pages mémoire « écrites » nouvellement marquées comme étant usées.

Les sous-blocs disjoints peuvent être formés de sorte à ne pas couper une donnée mémorisée sur plusieurs pages mémoire consécutives.

Le taux d'usure globale peut être représentatif d'un nombre de pages mémoire de données usées ou d'une proportion de pages mémoire de données usées dans le bloc.

Par exemple, si le bloc est formé de X pages mémoire de données dont Y pages mémoire sont marquées comme usées, alors le taux d'usure globale du secteur est Y/X.

Si plusieurs blocs sont évalués à l'étape 320, seul celui présentant le plus haut taux d'usure globale est considéré.

Toujours à l'étape 320, le taux d'usure globale du bloc considéré est comparé à une valeur seuil, dite seuil d'usure globale, par exemple 90%.

Si le taux d'usure globale atteint le seuil d'usure globale, alors le procédé se poursuit à l'étape 325 (branche « O » de l'étape 320) visant à déplacer le contenu des pages de données de ce bloc vers la zone mémoire OS 201, 203 ; sinon (branche « N » de l'étape 320), le procédé retourne à l'étape 300 en attente d'une nouvelle instruction d'écriture de la mémoire NVM2.

L'étape 325 consiste donc à déplacer le contenu des pages mémoire de données du bloc vers la zone mémoire OS 201, 203, tout en déplaçant le contenu de l'ensemble des pages mémoire OS contenant l'ensemble du système d'exploitation vers des pages mémoire de données.

De préférence mais non nécessairement, ce déplacement consiste en l'interversion (i.e. la permutation ou l'échange) des contenus stockés dans le bloc de pages mémoire de données avec les contenus stockés dans la zone mémoire OS 201, 203.

La permutation des contenus peut être à la volée, donc immédiatement après l'étape 320. Une telle permutation, alors que l'élément sécurisé 107 est en cours d'utilisation, est possible car généralement le système d'exploitation en cours d'exécution a été chargée en mémoire vive RAM2 111. Aussi, il est possible de déplacer le code compilé statique du système d'exploitation.

En variante, notamment si une partie du système d'exploitation n'est pas chargé en mémoire vive RAM2 111 (et est donc susceptible d'être appelé à tout moment), il peut être préférable de reporter le déplacement effectif des contenus à un moment ultérieur, typiquement au prochain redémarrage (reboot) de l'élément sécurisé. Cela permet d'éviter d'effectuer le déplacement des contenus en même temps que l'élément sécurisé est utilisé, et donc de possibles risques d'erreurs d'écriture.

Dans ce mode de réalisation, il peut être d'abord prévu à l'étape 320, lorsqu'il est déterminé que le contenu du bloc doit être déplacé (car globalement trop usé), de marquer ce bloc comme étant à déplacer. A nouveau un drapeau associé au bloc peut être activé dans le registre 205, ou en variante un identifiant de bloc peut être mémorisé.

Puis, l'étape 325 de déplacement est réalisé au redémarrage de l'élément sécurisé 107. En d'autres termes, lors d'un redémarrage de l'élément sécurisé, une étape de vérification de si un bloc de pages mémoire de données est marqué comme étant à déplacer est réalisée. Dans l'affirmative, l'élément sécurisé déclenche le déplacement du contenu du bloc de pages mémoire de données marqué comme étant à déplacer vers la zone mémoire OS 201, 203.

Le redémarrage peut être laissé à l'initiative de l'utilisateur, par exemple lorsqu'il éteindra le dispositif hôte 100.

En variante, le procédé selon l'invention peut déclencher un tel redémarrage pour forcer le déplacement des contenus. L'instruction de redémarrage peut être prévue en fin d'étape 320. Aussi, le déclenchement du redémarrage de l'élément sécurisé est en réponse au marquage du bloc de pages mémoire de données comme étant à déplacer.

Comme illustré sur les Figures 2a et 2b, une mémoire de sauvegarde 206 est disponible pour permettre le déplacement. Cette mémoire peut former partie de la mémoire NVM2 ou non. Au sein de la mémoire NVM2, elle peut consister en une zone réservée et donc non utilisée pour le stockage de données, ou en variante être constituée de pages mémoire non usées et libres de la zone mémoire de données 202, 204. Aussi, la mémoire de sauvegarde 206 peut être de taille variable selon le nombre de pages mémoire libres lors de l'engagement de l'étape 325.

Le déplacement des contenus peut se faire en un seul bloc, signifiant que la mémoire de sauvegarde 206 est de la même taille que le bloc à déplacer. A titre d'exemple, le contenu du bloc de pages mémoire de données à déplacer est copié dans la mémoire de sauvegarde 206, puis le contenu de la zone mémoire OS 201, 203, de taille équivalente à celle du bloc de pages mémoire de données à déplacer, est à son tour copié dans les pages mémoire formant ledit bloc dont le contenu est déjà déplacé (donc ce contenu OS écrase l'ancien contenu de données copié en mémoire de sauvegarde 206), enfin le contenu en mémoire de sauvegarde 206 est recopié dans les pages mémoire de la zone mémoire OS 201, 203. En variante, ce peut être le contenu de l'ensemble des pages mémoire OS mémorisant le système d'exploitation qui est d'abord copié en mémoire de sauvegarde 206. Dans une autre variante, cela peut être l'ensemble de la première zone, formée des pages mémoires OS qui est copié en mémoire de sauvegarde 206. Dans une autre variante, la mémoire de sauvegarde 206 peut être doublée et recevoir une copie des deux contenus à intervertir, avant recopies interverties sur les pages mémoire initiales.

En variante, le déplacement peut être réalisé en sous-blocs. Cela permet d'utiliser une taille de mémoire de sauvegarde 206 réduite. Un sous-bloc peut notamment ne contenir qu'une seule page mémoire (unité minimale). Dans ce cas, le déplacement est progressif : le premier sous-bloc du bloc à déplacer et le premier sous-bloc de la zone mémoire OS 201, 203 sont intervertis en utilisant la mémoire de sauvegarde 206, puis le deuxième sous-bloc du bloc à déplacer et le deuxième sous-bloc de la zone mémoire OS 201, 203 sont intervertis, et ainsi de suite. Comme dans la variante ci-dessus, la mémoire de sauvegarde 206 peut être doublée pour recevoir une copie des deux sous-blocs à intervertir.

Le déplacement du contenu des pages mémoire (que ce soit les pages mémoire de données ou les pages mémoire OS) nécessite une mise à jour des adresses mémoire correspondant aux diverses données stockées.

A titre illustratif, une unité de gestion de mémoire (MMU pour « Memory Management Unit ») dans un contrôleur de mémoire, non représentés sur le Figure 1, tient à jour une table de correspondance ou « table de translation d'adresses » traduisant les adresses mémoire envoyées par le processeur CPU2 110 en des adresses physiques dans la mémoire. Le déplacement du contenu des pages mémoires modifie l'adresse physique de stockage du contenu. Aussi, lors du déplacement du contenu des pages mémoire de données, l'adresse physique de la table de translation d'adresses est mise à jour pour pointer vers la nouvelle adresse, correspondant aux pages mémoire OS de destination dans la zone mémoire OS 201, 203.

Le système d'exploitation d'un élément sécurisé comporte généralement, en dur au début du code compilé, une adresse mémoire absolue où est initialement stockée ce système d'exploitation. Il s'agit en d'autre termes de l'adresse mémoire débutant la zone mémoire OS 201, 203. Les autres adresses renseignées dans le code compilé du système d'exploitation sont généralement exprimées en adresses relatives par rapport à cette adresse absolue.

Le système d'exploitation n'étant pas recompilé lors du déplacement selon l'invention, il est prévu dans un ou plusieurs modes de réalisation, de mettre à jour un registre d'indirection pour stocker une information représentative d'une nouvelle adresse mémoire des contenus déplacés, ici de l'OS déplacé. Ce registre d'indirection, initialement mis à 0 lors de l'installation du système d'exploitation, peut comprendre le décalage mémoire ou « offset » entre l'adresse initiale et l'adresse destination du déplacement. Le décalage mémorisé peut simplement être ajoutées aux adresses de **chargement.** Ainsi, les adresses d'appel aux fonctions du système d'exploitation sont évaluées comme étant la somme de l'adresse absolue initiale de l'OS, de l'adresse relative de la fonction appelée et de la valeur d'indirection contenue dans le registre, et permettent donc, avant le déplacement et après le déplacement, d'effectuer les appels aux fonctions du système d'exploitation, sans risque.

Une fois le déplacement des contenus effectués (étape 325), le procédé se termine. En effet, le système d'exploitation est désormais stocké sur un bloc de pages mémoire globalement usé. Celles-ci ne constituent donc plus une réserve de pages mémoire « saines » pour une nouvelle mise en œuvre de l'invention.

La Figure 4 illustre, à l'aide d'un ordinogramme, des étapes d'un procédé de gestion d'une mémoire non volatile réinscriptible NVM2 selon un ou plusieurs modes de réalisation avec déplacement progressif (ou morcelé ou parcellaire) du système d'exploitation.

En effet, seule une partie du système d'exploitation peut se trouver être déplacée. Cela est notamment avantageux pour des éléments sécurisés dont le système d'exploitation occupe une partie prépondérante de l'espace mémoire NVM2. A titre d'illustration, il n'est pas inusuel d'utiliser des éléments sécurisés dotés d'une mémoire NVM2 de capacité 512 ko hébergeant un système d'exploitation de 300 ko.

Le système d'exploitation peut être « délocalisable » ou « relocalisable » et ainsi être structuré en sections pouvant être déplacées indépendamment les unes des autres, sous réserve de mettre à jour la table de relocalisation associée, comme expliqué plus haut. La Figure 2c illustre un système d'exploitation 207, nommé OS sur la figure, structuré en sections 208, dans la configuration mémoire de la Figure 2b. Il est également possible d'utiliser un système d'exploitation structuré en sections 208, dans la configuration mémoire partitionnée de la Figure 2a.

Dans ces exemples, le système d'exploitation stocké est donc un OS compilé, composé d'une pluralité de sections pouvant être stockées de façon indépendante, chacune étant stockée sur un bloc respectif de pages mémoire OS. Sur la Figure, la première section d'OS est stockée sur quatre pages mémoire (chaque bande horizontale représentant de façon schématique une page mémoire), la seconde section sur deux pages mémoire, etc.

A nouveau, la gestion de la mémoire selon la Figure 4 peut être mise en œuvre après épuisement des pages mémoire de données comme évoqué ci-dessus. Dans ce cas-là, le déplacement du contenu d'une page mémoire de données usée vers une page mémoire OS (de la zone 201, 203) est conditionné au fait que la zone mémoire de données 202, 204 ne comporte plus de page mémoire de données non usée ou « saine » qui soit libre.

A l'étape 400, l'élément sécurisé est en attente d'une instruction d'écriture dans la zone mémoire de données 202, 204, de façon similaire à l'étape 300 ci-dessus. Lorsqu'une telle instruction est reçue (branche « O » de l'étape 400), elle est exécutée à l'étape 405 (similaire à l'étape 305), conduisant à l'écriture sur une ou plusieurs pages mémoire de données, selon la taille des données à écrire ou à effacer. Si l'instruction reçue n'est pas une instruction d'écriture (branche « N » de l'étape 400), alors le procédé reboucle sur lui-même à l'étape 400 en attente d'une nouvelle instruction d'écriture. Avec ces étapes 400 et 405, la suite du procédé conduisant au déplacement de contenus de pages mémoire usées est conditionnée ou « en réponse » à une étape d'écriture d'une donnée sur une page mémoire de données. D'autres conditions pourraient néanmoins être utilisées.

A l'étape 410, similaire à l'étape 310 ci-dessus, un niveau d'usure de chacune des pages « écrites » est déterminé. A nouveau, le procédé décrit dans le brevet FR 2 977 047 B1 peut être utilisé à cette fin.

Une page mémoire « écrite » peut s'avérer être usée (branche « O » de l'étape 410) auquel cas elle est marquée comme telle à l'étape 415. Aussi, au fur et à mesure des différentes écritures en mémoire NVM2, chaque page mémoire de données « écrite » qui est déterminée comme usée est marquée comme telle.

Le niveau d'usure déterminé est par exemple considéré comme « usé » s'il dépasse une valeur seuil d'usure préfixée THR1. Dans l'exemple des mécanismes du brevet FR 2 977 047 B1, si la qualité d'effacement mesurée en comparant les tensions de seuil est inférieure à un seuil d'usure, alors la page mémoire est considérée comme usée (« état usé »).

Dans un ou plusieurs modes de réalisation, au moins deux états d'usure différents peuvent être évalués pour la page mémoire examinée, fonction de deux valeurs seuil respectives. Une première valeur seuil, ici la valeur seuil d'usure THR1 mentionnée précédemment, permet d'attribuer l'état « usé » à la page mémoire examinée ; une deuxième valeur seuil THR2, appelé valeur seuil d'usure critique, permet d'attribuer l'état « critique » à la page mémoire examinée. L'état « critique » étant plus contraignant que l'état « usé », la valeur seuil THR2 est plus élevée que la valeur seuil THR1 (« plus élevée » au sens représentative d'un niveau d'usure plus important, THR2 pouvant être mathématiquement plus petit que THR1). Dans ce cas, le marquage évoqué peut indiquer « non usé », « usé » ou « critique ». Bien entendu, un plus grand nombre d'états d'usure peut être utilisé dans le cadre de l'invention.

Le marquage peut alors consister en l'activation d'un drapeau « usée » ou l'indication de l'état (« usé » ou « critique ») dans un champ associé à la page mémoire considérée. Cette information peut être stockée dans le registre 205, pour chacune des pages mémoire de données, comme expliqué ci-dessus à l'étape 315. En variante à l'usage d'un drapeau/champ par page mémoire, un identifiant de la page mémoire (par exemple son adresse) peut être mémorisé dans le registre comme expliqué ci-dessus à l'étape 315. Eventuellement deux registres, l'un associé à l'état « usé » et l'autre à l'état « critique » peuvent être utilisés.

Si aucune page mémoire n'est identifiée comme nouvellement usée (branche « N » de l'étape 410), alors le procédé repart à l'étape 400 en attente d'une nouvelle instruction d'écriture.

Une fois toutes les pages mémoire « écrites » traitées (celles de l'étape 405) et lorsqu'au moins une nouvelle page est marquée comme étant usée ou critique (donc suite à l'étape 415), l'élément sécurisé détermine à l'étape 420 si le contenu de cette page mémoire usée doit être déplacé.

Plusieurs critères peuvent être utilisés comme décrits ci-après, qui sont combinables entre eux sauf incompatibilité manifeste. Par exemple, si une ou plusieurs pages mémoire sont marquées comme critiques, il peut être déterminé l'ensemble de pages mémoire contigües (comme expliqué ci-après) incluant cette ou ces pages mémoire « critique », qui présente le taux d'usure global le plus élevé, et procéder au déplacement indépendamment de la valeur de ce taux (le critère de déclenchement étant la simple présence d'une page « critique »). Egalement, il peut être nécessaire de s'assurer que toutes les pages mémoire d'un ensemble analysé sont de type 2 (voir ci-après).

Dans un ou plusieurs modes de réalisation relatifs à ces critères, le déplacement est systématique dès lors que la page mémoire est marquée comme usée.

Dans un ou plusieurs modes de réalisation relatifs à ces critères, le déplacement est déclenché si la page mémoire est marquée comme étant « critique ». Aussi, dans ces modes de réalisation, l'atteinte d'un taux d'usure particulier d'une page mémoire de données usée au-delà d'un seuil critique déclenche la procédure de déplacement.

Dans un ou plusieurs modes de réalisation relatifs à ces critères, le déplacement est basé sur un type de page mémoire de données associée à cette page mémoire usée. Par exemple, certaines pages peuvent être déclarées comme indéplaçables (pages de type 1) car leur contenu est sensible (clés cryptographiques, zone système, adresses mémoire de base, etc.). Ces pages peuvent constituer une zone protégée de la NVM2 ou être mélangées aux autres pages mémoire de données (auquel cas un marquage permet de les identifier). Les autres pages mémoire de données sont assujetties à une protection moindre et leur contenu peut donc être déplacé (pages de type 2).

Dans un ou plusieurs modes de réalisation relatifs à ces critères, le déplacement est basée sur un taux d'usure globale d'un ensemble de pages mémoire de données incluant la ou les pages mémoire nouvellement marquées comme usées.

L'élément sécurisé 107 peut par exemple analyser un ou plusieurs ensembles de pages mémoire de données contigües, incluant chacun la ou les pages mémoire nouvellement marquées comme usées, puis évaluer un taux d'usure globale de chacun de ces ensembles. Cela peut par exemple permettre de déclencher le déplacement du contenu d'un ensemble de pages mémoire de données contigües incluant la première page mémoire usée, en cas d'identification que cet ensemble de pages mémoire de données contigües présente un taux d'usure globale supérieur à un seuil d'usure globale.

Des considérations similaires à celles évoquées en lien avec l'étape 320 plus haut sont applicables.

A noter que des ensembles de tailles variables peuvent être analysés. Typiquement l'élément sécurisé 107 peut analyser tous les ensembles composés de A à B pages mémoire de données contigües (A, B entiers préfixés, par exemple A = 2 et B = un dixième de la taille de la zone mémoire OS 201, 203) et rechercher celui qui présente le taux d'usure globale le plus élevé.

Dans un ou plusieurs modes de réalisation, comme il peut être préférable de déplacer le contenu d'un ensemble substantiel de pages mémoire d'un coup, le taux d'usure globale peut inclure une pondération du ratio Y/X (décrit plus haut à l'étape 320, mis à l'échelle de l'ensemble considéré ici) par le nombre de pages mémoire formant l'ensemble analysé. Par exemple, le taux d'usure globale peut être égal à Y/X².

Il est question ici de déterminer si une sous-partie de la zone mémoire de données 202, 204 se retrouve être trop dégradée, justifiant un déplacement de son contenu vers la zone mémoire OS 201, 203.

Si le taux d'usure globale de l'ensemble considéré atteint le seuil d'usure globale (branche « O » de l'étape 420), alors le procédé se poursuit à l'étape 425 visant à sélectionner une ou plusieurs des sections 208 de l'OS 207. Si le taux d'usure globale de l'ensemble considéré n'atteint pas le seuil d'usure globale (branche « N » de l'étape 420), alors le procédé repart à l'étape 400 en attente d'une nouvelle instruction d'écriture.

Dans un ou plusieurs modes de réalisation, la sélection visée à l'étape 425 consiste à sélectionner le plus petit ensemble (en nombre de pages mémoire OS associées) d'une ou plusieurs sections contiguës de l'OS ayant une taille supérieure à l'ensemble obtenu (à l'étape 420) de pages mémoire de données. On cherche ainsi à identifier la partie de zone mémoire OS la plus en adéquation (en terme de taille) avec les pages mémoire globalement usées à déplacer.

Dans le présent texte, déplacer une page mémoire, déplacer un bloc, déplacer une section sont à comprendre au sens de « déplacer le contenu » qui est mémorisé dans la ou les pages mémoires considérées, dans le ou les blocs considérés ou la ou les sections considérées.

Bien entendu, seules les sections de l'OS non encore déplacées, c'est-à-dire toujours dans la zone mémoire OS 201, 203 initiale, sont prises en compte. Cela permet d'assurer qu'une page mémoire OS vers laquelle est déplacé le contenu de la première page mémoire de données usée (donc destination d'un déplacement de contenu) soit distincte d'une page mémoire usée dans laquelle le contenu d'une page mémoire OS a déjà été déplacé.

Une fois cette ou ces sections identifiées, l'étape optionnelle 430 consiste pour l'élément sécurisé à déterminer un bloc final de page mémoire de données à déplacer. Cette étape est optionnelle, car il peut être décidé de déplacer uniquement l'ensemble obtenu à l'étape 420 (éventuellement une unique page mémoire de données).

Le bloc final à déplacer peut par exemple être obtenu en mettant à jour l'ensemble de pages mémoire de données obtenu à l'étape 420, par exemple par ajout de pages mémoire de données voisines précédant et/ou succédant ledit ensemble, en fonction de la ou les sections d'OS sélectionnées. Idéalement, l'ensemble de pages mémoire de données est augmenté jusqu'à atteindre la taille de la ou les sections d'OS sélectionnées à l'étape 425. Il est bien entendu tenu compte des données stockées dans cet ensemble augmenté, afin de ne pas les tronquer. Aussi, l'ensemble augmenté formant le bloc final a une taille équivalente, possiblement égale, à celle de la ou les sections d'OS sélectionnées.

Une fois le bloc de pages mémoire à déplacer obtenu à l'étape 430, son contenu est déplacé, lors de l'étape 435, vers la zone mémoire OS 201, 203, typiquement en intervertissant ce contenu avec celui du bloc de pages mémoire OS correspondant à la ou les sections sélectionnées.

Cela garantit que le contenu de la page (ou plusieurs pages) mémoire de données nouvellement marquée comme usée à l'étape 415 soit déplacé vers une page mémoire OS stockant la ou les sections sélectionnées, et que réciproquement la ou les sections sélectionnées soient déplacées vers un bloc de page mémoire de données.

Néanmoins, il peut être prévu que le contenu stocké sur la ou les sections sélectionnées (possiblement une unique page mémoire OS) soit déplacé vers une ou des pages mémoire de données disponibles, préférablement globalement usées (selon un taux d'usure globale) différentes du bloc de pages mémoire de données (possiblement l'unique page mémoire nouvellement marquée comme usée) dont le contenu est déplacé en parallèle.

Des considérations similaires à celles exposées plus haut en lien avec l'étape 325 sont applicables.

Notamment, la permutation des contenus peut être faite à la volée, ou lors de prochain redémarrage de l'élément sécurisé (auquel cas il est mis en place un marquage indiquant lorsque le bloc de pages mémoire obtenu à l'étape 430 est à déplacer).

Egalement, le déplacement des contenus peut se faire en un seul bloc ou en sous-blocs, selon la taille de la mémoire de sauvegarde 206 disponible.

Enfin, les adresses mémoire sont mises à jour, typiquement dans la table de translation d'adresses pour les données, et via le registre d'indirection et/ou la table de relocalisation pour la ou les sections d'OS déplacées

Une fois le déplacement des contenus effectués (étape 435), l'étape 440 peut consister à vérifier s'il reste au moins une section d'OS non déplacée. En effet, dans cette condition, il demeure une réserve de pages mémoire « saines » dont l'invention pourrait tirer profit afin de prolonger la durée de vie de la mémoire NVM2.

Aussi, dans l'affirmative de l'étape 440 (branche « O » de l'étape 440), le procédé retourne à l'étape 400 dans l'attente d'une nouvelle instruction d'écriture. Sinon (branche « N » de l'étape 440), le procédé se termine car il n'y a plus de réserve de pages mémoire « saines » pour une nouvelle mise en œuvre de l'invention.

La description ci-dessus envisage à titre principale le déplacement du contenu d'une page mémoire de données vers une page mémoire OS afin de bénéficier de la faible usure de ces dernières. Dès lors qu'il demeure des pages mémoire OS (ou section d'OS) non encore déplacées, il est également possible de déplacer à nouveau un contenu de données déjà déplacé vers une page mémoire OS, vers une nouvelle page mémoire OS si la première page mémoire OS s'avère être usée (par exemple par de multiples réécritures des données qu'elle contient).

Aussi, certains modes de réalisation peuvent envisager que l'élément sécurisé : détermine qu'une première page mémoire OS vers laquelle le contenu d'une page mémoire de données usée a déjà été déplacé, est usée,
et en réponse à cette détermination, déplace ledit contenu de cette première page mémoire OS désormais usée vers une second page mémoire OS (dont le contenu n'a pas encore été déplacé).

Les principes de déplacement de contenu, de détermination d'un état usé (voire critique) tels que définis plus haut s'appliquent également ici.

Comme il ressort de ce qui précède, l'invention permet par conséquent de prolonger, de façon notable, la durée de vie d'un élément sécurisé.

Bien entendu, la présente invention ne se limite pas aux formes de réalisation décrites ci-avant à titre d'exemples ; elle s'étend à d'autres variantes. D'autres réalisations sont possibles.

En fonction du mode de réalisation choisi, certains actes, actions, évènements ou fonctions de chacune des méthodes décrites dans le présent document peuvent être effectués ou se produire selon un ordre différent de celui dans lequel ils ont été décrits, ou peuvent être ajoutés, fusionnés ou bien ne pas être effectués ou ne pas se produire, selon le cas. En outre, dans certains modes de réalisation, certains actes, actions ou évènements sont effectués ou se produisent concurremment et non pas successivement.

Bien que décrits à travers un certain nombre d'exemples de réalisation détaillés, le procédé proposé et l'équipement pour la mise en œuvre du procédé comprennent différentes variantes, modifications et perfectionnements qui apparaîtront de façon évidente à l'homme de l'art, étant entendu que ces différentes variantes, modifications et perfectionnements font partie de la portée de l'invention, telle que définie par les revendications qui suivent. De plus, différents aspects et caractéristiques décrits ci-dessus peuvent être mis en œuvre ensemble, ou séparément, ou bien substitués les uns aux autres, et l'ensemble des différentes combinaisons et sous combinaisons des aspects et caractéristiques font partie de la portée de l'invention. En outre, il se peut que certains systèmes et équipements décrits ci-dessus n'incorporent pas la totalité des modules et fonctions décrits pour les modes de réalisation préférés.

## Revendications

1. Procédé de gestion d'une mémoire non volatile réinscriptible (108) dans un élément sécurisé (107), la mémoire comportant une première zone (201, 203, 207) formée de pages mémoire, dites pages mémoire OS, stockant un système d'exploitation, OS, et une seconde zone (202 , 204) formée de pages mémoire, dites pages mémoire de données, pour stocker des données, le procédé comprenant les étapes suivantes :
- déterminer (310, 410) si au moins une première page mémoire de données est usée, et
- dans l'affirmative, déplacer (325, 435) le contenu de la première page mémoire de données usée vers une page mémoire OS tout en déplaçant le contenu de cette page mémoire OS vers une page mémoire de données usée..

2. Procédé selon la revendication 1, dans lequel chaque page mémoire de données déterminée comme usée est marquée (315) comme telle, et le déplacement comprend les étapes suivantes :
déterminer (320) un taux d'usure globale d'un bloc de pages mémoire de données, et
si le taux d'usure globale atteint un seuil d'usure globale, déplacer (325) le contenu des pages mémoire de données du bloc vers la première zone, tout en déplaçant le contenu de l'ensemble des pages mémoire OS contenant l'ensemble du système d'exploitation vers des pages mémoire de données.

3. Procédé selon la revendication 1, dans lequel l'OS stocké est un OS compilé (207), composé d'une pluralité de sections (208) pouvant être stockées de façon indépendante, chacune étant stockée sur un bloc respectif de pages mémoire OS, et le déplacement comprend les étapes suivantes :
sélectionner (425) une ou plusieurs des sections (208) de l'OS,
déplacer (435) le contenu de la première page mémoire de données usée vers une page mémoire OS stockant la ou les sections sélectionnées, tout en déplaçant le contenu du ou des blocs de pages mémoire OS stockant la ou les sections de l'OS sélectionnées vers un bloc de page mémoire de données.

4. Procédé selon la revendication 3, dans lequel sélectionner (425) une ou plusieurs des sections (208) de l'OS comprend sélectionner le plus petit ensemble d'une ou plusieurs sections contiguës de l'OS ayant une taille supérieure à l'ensemble obtenu de pages mémoire de données.

5. Procédé selon la revendication 3 ou 4, dans lequel le déplacement (435) est déclenché par l'identification (420) d'un ensemble de pages mémoire de données contigües, incluant la première page mémoire de données usée, présentant un taux d'usure globale supérieur à un seuil d'usure globale.

6. Procédé selon l'une quelconque des revendications 1 à 5, comprenant en outre une étape consistant à déterminer (320, 420) si le contenu de la première page mémoire de données usée doit être déplacé.

7. Procédé selon la revendication 6, dans lequel la détermination de si le contenu de la première page mémoire de données usée doit être déplacé est basée sur un type de page mémoire de données associé à la première page mémoire de données usée.

8. Procédé selon la revendication 6, dans lequel dans l'affirmative d'une détermination que le contenu de la première page mémoire de données usée doit être déplacé, la première page mémoire de données usée est marquée comme étant à déplacer, et
le procédé comprend en outre, lors d'un redémarrage de l'élément sécurisé, une étape de vérification de si une page mémoire de données usée est marquée comme étant à déplacer, et dans l'affirmative une étape de déclenchement du déplacement du contenu de ladite page mémoire de données marquée comme étant à déplacer, vers la page mémoire OS.

9. Procédé selon l'une quelconque des revendications 1 à 8, comprenant, en outre, une mise à jour d'un registre d'indirection pour stocker une information représentative d'une nouvelle adresse mémoire des contenus déplacés.

10. Procédé selon l'une quelconque des revendications 1 à 9, comprenant en outre, lorsque la page mémoire OS vers laquelle a été déplacé le contenu de la première page mémoire de données usée est déterminée comme étant usée, le déplacement dudit contenu de cette page mémoire OS usée vers une seconde page mémoire OS.

11. Elément sécurisé (107) comprenant un processeur (110) et une mémoire non-volatile réinscriptible (108), la mémoire non-volatile réinscriptible comportant une première zone (201, 203, 207) formée de pages mémoire, dites pages mémoire OS, stockant un système d'exploitation, OS, et une seconde zone (202, 204) formée de pages mémoire, dites pages mémoire de données, pour stocker des données, l'élément sécurisé étant configuré pour :
- déterminer si au moins une première page mémoire de données est usée, et
- dans l'affirmative, déplacer le contenu de la première page mémoire de données usée vers une page mémoire OS tout en déplaçant le contenu de cette page mémoire OS vers une page mémoire de données usée.

12. Support d'enregistrement non transitoire lisible par un ordinateur sur lequel est enregistré un programme pour la mise en œuvre du procédé selon l'une des revendications 1 à 10 lorsque ce programme est exécuté par un processeur.

## Patentansprüche

1. Verfahren zur Verwaltung eines wiederbeschreibbaren nichtflüchtigen Speichers (108) in einem sicheren Element (107), wobei der Speicher einen ersten Bereich (201, 203, 207), der aus als OS-Speicherseiten bezeichneten Speicherseiten gebildet wird, die ein Betriebssystem, OS, speichern, und einen zweiten Bereich (202, 204), der aus als Datenspeicherseiten bezeichneten Speicherseiten zum Speichern von Daten gebildet wird, umfasst, wobei das Verfahren die folgenden Schritte umfasst:
- Ermitteln (310, 410), ob mindestens eine erste Datenspeicherseite abgenutzt ist, und
- falls ja, Verschieben (325, 435) des Inhalts der abgenutzten ersten Datenspeicherseite zu einer OS-Speicherseite, während der Inhalt dieser OS-Speicherseite zu einer abgenutzten Datenspeicherseite verschoben wird.

2. Verfahren nach Anspruch 1, wobei jede als abgenutzt ermittelte Datenspeicherseite als solche gekennzeichnet (315) wird und das Verschieben die folgenden Schritte umfasst:
Ermitteln (320) einer Gesamtabnutzungsrate eines Blocks von Datenspeicherseiten, und
wenn die Gesamtabnutzungsrate einen Gesamtabnutzungsschwellenwert erreicht, Verschieben (325) des Inhalts der Datenspeicherseiten des Blocks zu dem ersten Bereich, während der Inhalt des Satzes der OS-Speicherseiten, die den Satz des Betriebssystems enthalten, zu Datenspeicherseiten verschoben wird.

3. Verfahren nach Anspruch 1, **dadurch gekennzeichnet, dass** das gespeicherte OS ein kompiliertes OS (207) ist, das aus mehreren Abschnitten (208) besteht, die unabhängig gespeichert werden können, wobei jeder auf einem jeweiligen Block von OS-Speicherseiten gespeichert ist, und das Verschieben die folgenden Schritte umfasst:
Auswählen (425) eines oder mehrerer der Abschnitte (208) des OS,
Verschieben (435) des Inhalts der abgenutzten ersten Datenspeicherseite zu einer OS-Speicherseite, die den oder die ausgewählten Abschnitte speichert, während der Inhalt des oder der Blöcke von OS-Speicherseiten, die den oder die ausgewählten Abschnitte des OS speichern, zu einem Block von Datenspeicherseiten verschoben wird.

4. Verfahren nach Anspruch 3, wobei das Auswählen (425) eines oder mehrerer der Abschnitte (208) des OS das Auswählen des kleinsten Satzes aus einem oder mehreren zusammenhängenden Abschnitten des OS umfasst, der eine Größe hat, die größer als der erhaltene Satz von Datenspeicherseiten ist.

5. Verfahren nach Anspruch 3 oder 4, wobei das Verschieben (435) durch die Identifizierung (420) eines Satzes von zusammenhängenden Datenspeicherseiten ausgelöst wird, der die abgenutzte erste Datenspeicherseite beinhaltet und einen Gesamtabnutzungsgrad aufweist, der größer als ein Gesamtabnutzungsschwellenwert ist.

6. Verfahren nach einem der Ansprüche 1 bis 5, umfassend ferner einen Schritt, der darin besteht zu ermitteln (320, 420), ob der Inhalt der abgenutzten ersten Datenspeicherseite verschoben werden muss.

7. Verfahren nach Anspruch 6, wobei das Ermitteln, ob der Inhalt der abgenutzten ersten Datenspeicherseite verschoben werden muss, auf einem Datenspeicherseitentyp basiert, der der abgenutzten ersten Datenspeicherseite zugeordnet ist.

8. Verfahren nach Anspruch 6, wobei, wenn ermittelt wird, dass der Inhalt der abgenutzten ersten Datenspeicherseite verschoben werden muss, die abgenutzte erste Datenspeicherseite als zu verschieben kennzeichnet wird, und
das Verfahren ferner, bei einem Neustart des sicheren Elements, einen Schritt des Überprüfens, ob eine abgenutzte Datenspeicherseite als zu verschieben gekennzeichnet ist, und, falls ja, einen Schritt des Auslösens des Verschiebens des Inhalts der als zu verschieben gekennzeichneten Datenspeicherseite zu der OS-Speicherseite umfasst.

9. Verfahren nach einem der Ansprüche 1 bis 8, umfassend ferner eine Aktualisierung eines Indirektionsregisters, um eine Information zu speichern, die repräsentativ für eine neue Speicheradresse der verschobenen Inhalte ist.

10. Verfahren nach einem der Ansprüche 1 bis 9, umfassend ferner, wenn die OS-Speicherseite, zu welcher der Inhalt der abgenutzten ersten Datenspeicherseite verschoben worden ist, als abgenutzt ermittelt wird, das Verschieben des Inhalts dieser abgenutzten OS-Speicherseite zu einer zweiten OS-Speicherseite.

11. Sicheres Element (107), das einen Prozessor (110) und einen wiederbeschreibbaren nichtflüchtigen Speicher (108) umfasst, wobei der wiederbeschreibbare nichtflüchtige Speicher einen ersten Bereich (201, 203, 207), der aus als OS-Speicherseiten bezeichneten Speicherseiten gebildet wird, die ein Betriebssystem, OS, speichern, und einen zweiten Bereich (202, 204), der aus als Datenspeicherseiten bezeichneten Speicherseiten zum Speichern von Daten gebildet wird, umfasst, wobei das sichere Element ausgelegt ist zum:
- Ermitteln, ob mindestens eine erste Datenspeicherseite abgenutzt ist, und
- falls ja, Verschieben des Inhalts der abgenutzten ersten Datenspeicherseite zu einer OS-Speicherseite, während der Inhalt dieser OS-Speicherseite zu einer abgenutzten Datenspeicherseite verschoben wird.

12. Computerlesbares nichttransitorisches Speichermedium, auf dem ein Programm gespeichert ist, das bei der Ausführung dieses Programms durch einen Prozessor das Verfahren nach einem der Ansprüche 1 bis 10 durchführt.

## Claims

1. Method for managing a rewritable non-volatile memory (108) in a secure element (107), the memory comprising a first area (201, 203, 207) formed of memory pages, called OS memory pages, storing an operating system, OS, and a second area (202, 204) formed of memory pages, called data memory pages, for storing data, the method comprising the following steps:
- determining (310, 410) whether at least one first data memory page is worn out, and
- if so, moving (325, 435) the content of the worn-out first data memory page to an OS memory page while moving the content of this OS memory page to a worn-out data memory page.

2. Method according to Claim 1, wherein each data memory page determined as worn out is marked (315) as such, and the movement comprises the following steps:
determining (320) an overall wear level of a block of data memory pages, and
if the overall wear level reaches an overall wear threshold, moving (325) the content of the data memory pages of the block to the first area, while moving the content of all of the OS memory pages containing the whole operating system to data memory pages.

3. Method according to Claim 1, wherein the stored OS is a compiled OS (207), consisting of a plurality of sections (208) able to be stored independently, each one being stored on a respective block of OS memory pages, and the movement comprises the following steps:
selecting (425) one or more of the sections (208) of the OS,
moving (435) the content of the worn-out first data memory page to an OS memory page storing the selected one or more sections, while moving the content of the one or more blocks of OS memory pages storing the selected one or more sections of the OS to a block of data memory pages.

4. Method according to Claim 3, wherein selecting (425) one or more of the sections (208) of the OS comprises selecting the smallest set of one or more contiguous sections of the OS having a size greater than the obtained set of data memory pages.

5. Method according to Claim 3 or 4, wherein the movement (435) is triggered by the identification (420) of a set of contiguous data memory pages, including the worn-out first data memory page, having an overall wear level greater than an overall wear threshold.

6. Method according to any one of Claims 1 to 5, furthermore comprising a step of determining (320, 420) whether the content of the worn-out first data memory page should be moved.

7. Method according to Claim 6, wherein determining whether the content of the worn-out first data memory page should be moved is based on a type of data memory page associated with the worn-out first data memory page.

8. Method according to Claim 6, wherein, if it is determined that the content of the worn-out first data memory page should be moved, the worn-out first data memory page is marked as needing to be moved, and
the method furthermore comprises, when the secure element is restarted, a step of checking whether a worn-out data memory page is marked as needing to be moved, and if it is, a step of triggering the movement of the content from said data memory page marked as needing to be moved, to the OS memory page.

9. Method according to any one of Claims 1 to 8, furthermore comprising updating an indirection register to store information representative of a new memory address of the moved contents.

10. Method according to any one of Claims 1 to 9, furthermore comprising, when the OS memory page to which the content of the worn-out first data memory page has been moved is determined as being worn out, moving said content from this worn-out OS memory page to a second OS memory page.

11. Secure element (107) comprising a processor (110) and a rewritable non-volatile memory (108), the rewritable non-volatile memory comprising a first area (201, 203, 207) formed of memory pages, called OS memory pages, storing an operating system, OS, and a second area (202, 204) formed of memory pages, called data memory pages, for storing data, the secure element being configured to:
- determine whether at least one first data memory page is worn out, and
- if so, move the content of the worn-out first data memory page to an OS memory page while moving the content of this OS memory page to a worn-out data memory page.

12. Computer-readable non-transient recording medium on which there is recorded a program for implementing the method according to one of Claims 1 to 10 when this program is executed by a processor.
